(19) Europäisches Patentamt
European Patent Office
Office européen des brevets

(11) **EP 4 027 149 B1**

(12) **EUROPEAN PATENT SPECIFICATION**

(45) Date of publication and mention
of the grant of the patent:
**31.07.2024 Bulletin 2024/31**

(21) Application number: **21150926.0**

(22) Date of filing: **11.01.2021**

(51) International Patent Classification (IPC):
***G01R 13/02*** *(2006.01)*

(52) Cooperative Patent Classification (CPC):
**G01R 13/0218; G01R 13/0272**

(54) **PARALLEL FILTER STRUCTURE, OSCILLOSCOPE AND METHOD OF PROCESSING A SIGNAL**

PARALLELFILTERSTRUKTUR, OSZILLOSKOP UND VERFAHREN ZUR VERARBEITUNG EINES SIGNALS

STRUCTURE DE FILTRE PARALLÈLE, OSCILLOSCOPE ET PROCÉDÉ DE TRAITEMENT D'UN SIGNAL

(84) Designated Contracting States:
**AL AT BE BG CY CZ DE DK EE ES FI FR GB GR HR HU IS IT LT LU LV MC MK MT NL NO PL PT RO RS SE SI SK SM TR**

(43) Date of publication of application:
**13.07.2022 Bulletin 2022/28**

(73) Proprietor: **Rohde & Schwarz GmbH & Co. KG**
**81671 München (DE)**

(72) Inventor: **Nitsch, Bernhard**
**81671 München (DE)**

(74) Representative: **Novagraaf Group**
**Chemin de l'Echo 3**
**1213 Onex (CH)**

(56) References cited:
**US-A1- 2005 220 185     US-A1- 2016 344 372**
**US-B1- 9 077 574**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**EP 4 027 149 B1**

**Description**

The invention relates to a parallel filter structure for processing a signal. Further, the invention relates to an oscilloscope. In addition, the invention also relates to a method of processing a signal.

In test and measurement instruments, e.g. oscilloscopes, it is known that an input signal is processed such that a time and value discrete input signal is obtained, namely a digitized signal. The digitized signal may be inputted directly or rather gathered by processing an analog input signal, namely sampling the analog input signal, thereby obtaining samples.

The time and value discrete input signal is internally processed by the test and measurement instrument in order to obtain certain information that is outputted, for instance via an eye diagram. Therefore, the time and value discrete input signal is internally processed by a filter structure, for instance a decision feedback equalizer (DFE) module. The decision feedback equalizer module is a filter that utilizes its previous decisions in making a decision on the present signal (portion) to be processed.

In addition to the eye diagram functionality, the test and measurement instrument may also comprise a real-time trigger functionality that is usually realized by means of a continuous time linear equalizer (CTLE) together with a feed forward equalizer (FFE) module that requires less hardware resources compared to a decision feedback equalizer module due to its feedforward structure. Typically, the CTLE is used by a clock recovery (CR) to open an eye within the eye diagram of the signal distorted by the transmission channel to the extent that the CR is enabled to estimate the symbol clock.

However, the FFE and the DFE have different equalization characteristics, resulting in different equalization functions when processing the same signal, yielding problems concerning the comparability of the respective output signals of both equalizer modules.

In US 9 077 574 B1, a filter structure is shown wherein a feed forward equalizer (FFE) is followed by a decision feedback equalizer (DFE) which are connected in series with each other such that the feed forward equalizer (FFE) receives and processes a signal obtained from an ADC, whereas the subsequent decision feedback equalizer (DFE) receives and processes the signal already processed by the feed forward equalizer (FFE).

US 2016/344372 A1 shows an equalization filter.

In US 2005/220185 A1, a low cost and high speed equalizing receiver structure is described.

Accordingly, there is a need for an improved internal processing of a signal.

The invention provides a parallel filter structure for processing a signal. The parallel filter structure comprises a signal input configured to receive a time and value discrete input signal. The parallel filter structure comprises a feed forward equalizer (FFE) module connected with the signal input for receiving the time and value discrete input signal. The parallel filter structure comprises a decision feedback equalizer (DFE) module connected with the signal input for receiving the time and value discrete input signal, namely the same one as the FFE module. The feed forward equalizer module and the decision feedback equalizer module together form a parallel circuit such that both equalizer modules process the same time and value discrete input signal in parallel.

Accordingly, the parallel filter structure comprises both the feed forward equalizer module and the decision feedback equalizer module that together form the parallel circuit such that both equalizer modules process the same time and value discrete input signal in parallel. Therefore, respective output signals of the equalizer modules are obtained that are based on the same time and value discrete input signal.

In general, the FFE module is a finite impulse response (FIR) filter that is used to compensate pre- and post-oscillations of a channel impulse response, thereby reducing the influence of an inter-symbol interference (ISI) on the symbol decision, thereby reducing the risk of false decision. In fact, the FFE module is enabled to enlarge the eye opening in a respective eye diagram.

The DFE module is a combination of a finite impulse response (FIR) filter and an infinite impulse response (IIR) filter, thereby providing two filter portions, namely a FIR portion for compensating the pre- and post-oscillations of the channel impulse response as well as an IIR portion for only compensating post-oscillations of the channel impulse response. Thus, the DFE module has filter coefficients or rather equalizer parameters that are associated with the FIR portion and the IIR portion, respectively. Due to the additional IIR characteristics, the DFE module requires less filter coefficients or rather equalizer parameters compared with the FFE module.

In general; the FFE module may be used for equalizing pre-cursor samples of the channel impulse response; whereas the DFE module is used to equalize post-cursor samples. Accordingly, the DFE module is more robust in application scenarios with high noise content, as the symbol decision has noise-suppressing properties. Thus, the FFE module is preferred in application scenarios with high ISI components.

An aspect provides that the feed forward equalizer module and the decision feedback equalizer module are communicatively connected with each other. In other words, a communication line is established between both equalizer modules. Therefore, data and/or information may be exchanged among the respective equalizer modules, thereby ensuring that certain settings of the equalizer modules may be adapted based on data/information provided by the other equalizer module accordingly. For instance, the data and/or information is gathered from the output signal(s) of the respective equalizer module(s).

Another aspect provides that at least one feed forward equalizer parameter of the feed forward equalizer module is set depending on at least one decision feedback equalizer parameter of the decision feedback equalizer module. The respective equalizer parameter relates to a filter parameter of the corresponding equalizer module. In other words, the setting of the feed forward equalizer module is done at least partly based on the decision feedback equalizer module, namely a filter parameter associated therewith. Put differently, a respective filter parameter of the decision feedback equalizer module is outputted or rather derived, e.g. from the output signal, based on which the filter parameter of the feed forward equalizer module is parameterized.

Generally, the communication established between both equalizer modules ensures that their equalizing properties or rather equalizing characteristics are adapted with respect to each other, thereby obtaining equivalent equalizing functions.

The dependency may be determined based on a minimum of a cost function. Particularly, the parallel filter structure comprises a processing module that is configured to minimize the respective cost function. The at least one decision feedback equalizer parameter based on which the feed forward equalizer parameter is set may be used by the respective cost function that is minimized.

Particularly, the cost function comprises the error squared between an output signal of the feed forward equalizer module and an output signal of the decision feedback equalizer module. Therefore, the output signals of both equalizer modules are set in relation to each other, wherein the respective deviations are squared, thereby generating the cost function that shall be minimized in order to identify the respective parametrization for the feed forward equalizer module, namely the setting of the at least one feed forward equalizer parameter.

A further aspect provides that the parallel filter structure is implemented on a single chip, particularly an application-specific integrated circuit (ASIC). Alternatively, a field-programmable gate array (FPGA) may be used. Therefore, a single chip may be provided that encompasses the feed forward equalizer module and the decision feedback equalizer module that are established as the parallel circuit on the single chip. Further, the chip comprises the signal input that is connected with the parallel circuit, namely the feed forward equalizer module and the decision feedback equalizer module.

For instance, the feed forward equalizer module is implemented in a real time section of the chip. This ensures that the feed forward equalizer module can be used for a respective trigger functionality, particularly a real-time trigger functionality.

Further, the decision feedback equalizer module may be implemented in a non-real time section of the chip. The decision feedback equalizer module has a feedback structure such that it may be located in the non-time critical section of the chip.

Another aspect provides that an output signal of the feed forward equalizer module is fed to an interface for a trigger module. Particularly, the parallel filter structure comprises the trigger module that is connected with the feed forward equalizer module. The output signal of the feed forward equalizer module may be used for the respective (real-time) trigger functionality, wherein the trigger module may be employed on the parallel filter structure itself.

Alternatively, the interface for the trigger module corresponds to an output interface of the parallel filter structure, particularly the single chip, via which the parallel filter structure is connected with a separately formed chip on which the trigger module is provided.

Further, an output signal of the decision feedback equalizer module may be fed to an interface for an eye diagram module. Particularly, the parallel filter structure comprises the eye diagram module that is connected with the decision feedback equalizer module. The output signal of the decision feedback equalizer module may be used for the respective eye diagram functionality, wherein the eye diagram module may be employed on the parallel filter structure itself.

Alternatively, the interface for the eye diagram module corresponds to an output interface of the parallel filter structure, particularly the single chip, via which the parallel filter structure is connected with a separately formed chip on which the eye diagram module is provided.

The invention further provides an oscilloscope with a parallel filter structure described above. Thus, the characteristics and advantages mentioned above with regard to the parallel filter structure also apply to the oscilloscope in a similar manner. The oscilloscope may also comprise a sampling module that samples or rather digitizes an analog input signal, thereby generating the time and value discrete input signal that is forwarded to the parallel filter structure, particularly its signal input.

The oscilloscope may comprise a trigger module that is connected with an interface associated with a feed forward equalizer module that is separately formed with respect to the trigger module. The trigger module may be established on a separately formed chip with respect to the chip on which the feed forward equalizer module is provided, particularly the entire parallel filter structure. Accordingly, the oscilloscope comprises at least two separately formed chips that are connected with each other.

Another aspect provides that the oscilloscope comprises an eye diagram module that is connected with an interface associated with the decision feedback equalizer module that is separately formed with respect to the eye diagram module. The eye diagram module may be established on a separately formed chip with respect to the chip on which the decision feedback equalizer module is provided, particularly the entire parallel filter structure. Accordingly, the oscilloscope comprises at least two separately formed chips that are connected with each other.

Particularly, the oscilloscope comprises at least three separately formed chips that are associated with the parallel filter structure, the trigger module and the eye diagram module.

The invention further provides a method of processing a signal. The method comprises the steps of:

- Receiving a time and value discrete input signal via a signal input,

- Filtering the time and value discrete input signal by means of a feed forward equalizer module of a parallel filter structure,

- Filtering the time and value discrete input signal by means of a decision feedback equalizer module of the parallel filter structure, which together with the feed forward equalizer module forms a parallel circuit of the parallel filter structure such that both equalizer modules process the same time and value discrete input signal in parallel.

Accordingly, the parallel filter structure described above may be configured to perform the method of processing the signal. The time and value discrete input signal is processed by both equalizer modules of the parallel circuit in parallel, thereby providing two output signals in parallel, which are associated with the respective equalizer modules.

An aspect provides that at least one feed forward equalizer parameter of the feed forward equalizer module is set depending on at least one decision feedback equalizer parameter of the decision feedback equalizer module. Hence, the setting of the feed forward equalizer module is done at least partly based on the decision feedback equalizer module, namely a filter parameter associated therewith.

Particularly, the dependency is determined based on a minimum of a cost function. For instance, the cost function comprises the error squared between an output signal of the feed forward equalizer module and an output signal of the decision feedback equalizer module.

Generally, it is to be noted that the term "module" is understood to describe suitable hardware, suitable software, or a combination of hardware and software that is configured to have a certain functionality. The hardware may, inter alia, comprise a CPU, a GPU, an FPGA, an ASIC, or other types of electronic circuitry.

Further, if the sampling rate is significantly higher than the system clock rate of the chip, e.g. the ASIC or FPGA, then a high degree of parallelism must be selected for signal processing for real-time capable functions. This leads to the fact that the resource requirement of feedback structures, such as the IIR portion of the DFE module depends more on the parallelism and less on the filter length of the IIR portion. Then, the resource requirement of a FFE module is often lower than the resource requirement of a DFE module.

The foregoing aspects and many of the attendant advantages of the claimed subject matter will become more readily appreciated as the same become better understood by reference to the following detailed description, when taken in conjunction with the accompanying drawings. In the drawings,

- Figure 1 schematically shows an oscilloscope according to the invention, which comprises a parallel filter structure according to the invention,

- Figure 2 schematically shows a flow-chart that illustrates a method of processing a signal according to the invention,

- Figure 3 schematically shows an overview of a feed forward equalizer (FFE) module, and

- Figure 4 schematically shows an overview of a decision feedback equalizer (DFE) module.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

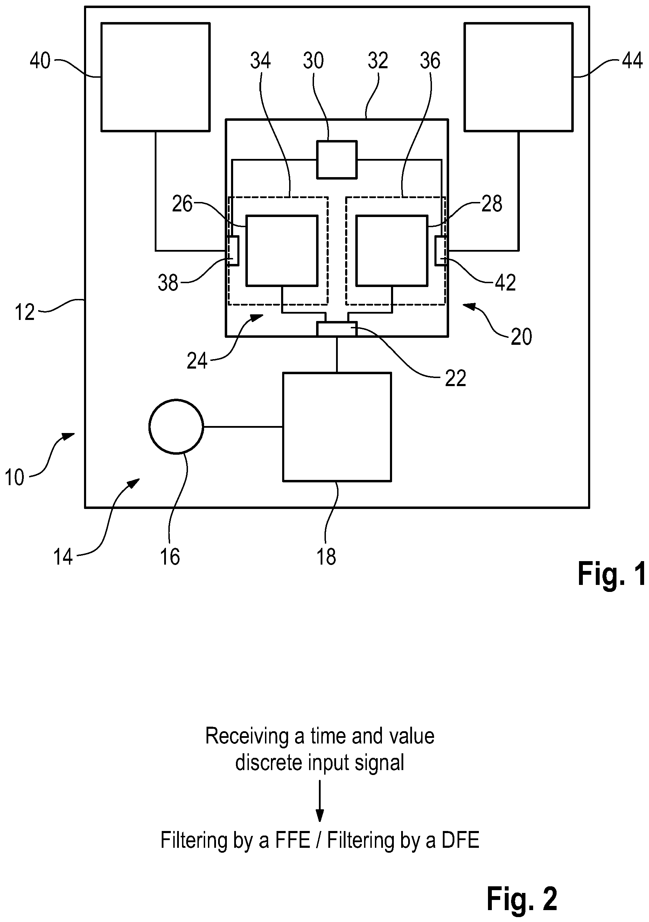

Figure 1 shows an oscilloscope 10 for processing a signal.

The oscilloscope 10 comprises a housing 12 with a front end 14. At the front end 14 of the oscilloscope 10 an analog input 16 is provided that is configured to receive an analog input signal.

The analog input 16 is connected with a sampling module 18 that processes the analog input signal in order to generate a digitized signal, namely a time and value discrete input signal.

The time and value discrete signal provided by the sampling module 18 is forwarded to a parallel filter structure 20 that processes the respective time and value discrete signal.

The parallel filter structure 20 has a signal input 22 via which the time and value discrete input signal is received.

In addition, the parallel filter structure 20 has a parallel circuit 24 that comprises two different equalizer modules, namely a feed forward equalizer module 26 as well as a decision feedback equalizer module 28.

Both equalizer modules 26, 28 are connected with the signal input 22 such that both modules 26, 28 receive the time and value discrete input signal that is processed by both equalizer modules 26, 28 in parallel.

This is generally shown in Figure 2.

In addition, the parallel filter structure 20 comprises a processing module 30 that is interconnected between both equalizer modules 26, 28, thereby establishing a communication connection between the equalizer modules 26, 28.

Accordingly, data/information of the respective equalizer modules 26, 28 may be gathered, particularly data/information of the decision feedback equalizer module 28, which may be used for setting at least one of the equalizer modules 26, 28 appropriately.

For instance, the processing module 30 is assigned to output interfaces of the respective equalizer modules 26, 28 such that output signals of the equalizer modules 26, 28 are forwarded to the processing module 30 that processes the respective output signals.

Again, the processing module 30 receives at least the output signal of the decision feedback equalizer module 28 in order to obtain information associated with the decision feedback equalizer module 28, which is used for controlling the feed forward equalizer module 26.

Generally, the respective equalizer modules 26, 28 each have respective parameters, also called filter parameters or rather filter coefficients, that are set/parameterized in order to define the respective processing of the time and value discrete input signal by the respective equalizer modules 26, 28.

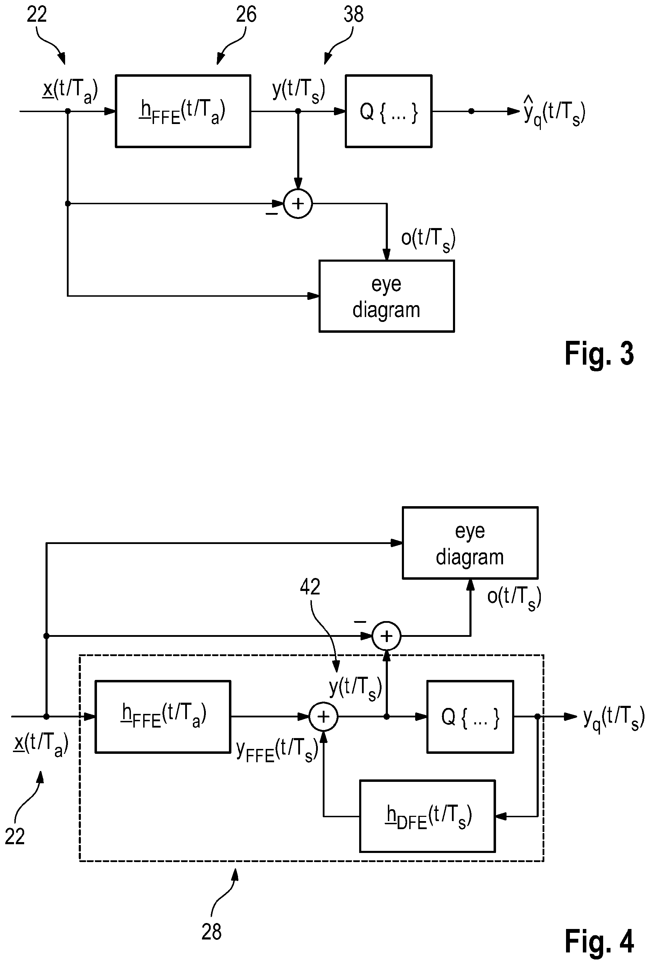

Schematic overviews of the equalizer modules 26, 28 are shown in Figures 3 and 4.

The FFE module 26 shown in Figure 3 is a finite impulse response (FIR) filter that is used to compensate pre- and post-oscillations of a channel impulse response:

$$y(t/T_s) = \underline{h}_{FFE}^T \cdot \underline{x}(t/T_s)$$

Accordingly, the influence of an inter-symbol interference (ISI) on the symbol decision is reduced, thereby reducing the risk of false decision.

The filter coefficients of the FFE module 26 are expressed by the vector

$$\underline{h}_{FFE} = [h_0 \quad h_1 \quad \cdots \quad h_{L_{FFE}-1}]^T \quad ,$$

with $L_{FFE}$ representing the length of the filter, namely the FFE module 26.

Further, the time and value discrete input signal is expressed by the following vector:

$$\underline{x}(t/T_s) = [x(t/T_s) \quad x(t/T_s - T_a/T_s) \quad \cdots \quad x(t/T_s - (L_{FFE} - 1) \cdot T_a/T_s)]^T$$

In the formulas, $T_S$ relates to the symbol rate, whereas $T_a$ relates to the sample rate.

In Figure 3, it is also shown that the symbol decision Q takes place based on the output signal of the FFE module 26, wherein the output signal may also be used for generating an eye diagram.

The DFE module 28 shown in Figure 4 is a combination of a finite impulse response (FIR) filter and an infinite impulse response (IIR) filter, thereby providing two filter portions, namely a FIR portion for compensating the pre- and post-oscillations of the channel impulse response as well as an IIR portion for only compensating post-oscillations of the channel impulse response. Hence, the signal processing of the DFE module 28 can be expressed as follows:

$$y(t/T_s) = \underline{h}_{FFE}^T \cdot \underline{x}(t/T_s) + \underline{h}_{DFE}^T \cdot \underline{y}_q(t/T_s - 1).$$

The FIR portion of the DFE module 28 can be expressed by the vector

$$\underline{h}_{FFE} = [h_{FFE,0} \quad h_{FFE,1} \quad \cdots \quad h_{FFE,L_{FFE}-1}]^T$$

and the IIR portion of the DFE module 28 can be expressed by the vector

$$\underline{h}_{DFE} = [h_{DFE,1} \quad h_{DFE,2} \quad \cdots \quad h_{DFE,L_{DFE}-1}]^T .$$

$L_{FFE}$ represents the length of the FIR filter portion, whereas $L_{DFE}$ represents the length of the IIR filter portion.

The time and value discrete input signal is expressed by the following vector:

$$\underline{x}(t/T_s) = [x(t/T_s) \quad x(t/T_s - T_a/T_s) \quad \cdots \quad x(t/T_s - (L_{FFE} - 1) \cdot T_a/T_s)]^T$$

The symbols decided can be expressed by the vector:

$$y_q(t/T_s - 1) = Q\{y(t/T_s - 1)\}.$$

In Figure 4, it is shown that the symbol decision Q takes place based on the output signal of the DFE module 28, wherein the output signal may also be used for generating an eye diagram. Obviously, the DFE module 28 has a feedback structure.

Generally, the equalizer modules 26, 28 may be trained by means of a method of least squares.

In case of the DFE module 28, the filter length of the IIR filter portion is set to 0.

The approach, which minimizes the mean square error between the equalized signal $y(t/T_S)$ and transmitted symbols $y_q(t/T_S)$, assumes that the error $e(t/T_S)$ of the equalized signal $y(t/T_S)$ is so small that no symbol error decisions occur in the symbol decision Q. It minimizes the mean square error between equalized signal $y(t/T_S)$ and transmitted symbols $y_q(t/T_S)$:

$$K = \left[\underline{X}(t/T_s) \cdot \underline{h}_{FFE} + \underline{Y}_q(t/T_s - 1) \cdot \underline{h}_{DFE} - \underline{y}_q(t/T_s)\right]^T \cdot \left[\underline{X}(t/T_s) \cdot \underline{h}_{FFE} + \underline{Y}_q(t/T_s - 1) \cdot \underline{h}_{DFE} - \underline{y}_q(t/T_s)\right]$$

wherein the matrix of the time and value discrete input signal is expressed by:

$$\underline{X}(t/T_s) = [\underline{x}^T(t/T_s + T_D/T_s) \quad \underline{x}^T(t/T_s + T_D/T_s - 1) \quad \cdots \quad \underline{x}^T(t/T_s + T_D/T_s - N + 1)]^T$$

and wherein the matrix of the transmitted symbols is expressed by:

$$\underline{Y}_q(t/T_s - 1) = [\underline{y}_q^T(t/T_s - 1) \quad \underline{y}_q^T(t/T_s - 2) \quad \cdots \quad \underline{y}_q^T(t/T_s - N)]^T$$

Moreover, N corresponds to the observation length of the observer. Moreover, the delay $T_D/T_S$ was introduced so that the respective FFE module 26 can also compensate for pre-cursors of the channel impulse response. Then, the cost function to be minimized can be expressed as follows

$$[\underline{h}_{FFE}^T \quad \underline{h}_{DFE}^T]^T = -1/2 \cdot \underline{\underline{A}}^{-1} \cdot \underline{b}$$

wherein the matrix A corresponds to:

$$\underline{\underline{A}} = [\underline{X}(t/T_s) \quad \underline{Y}_q(t/T_s - 1)]^T \cdot [\underline{X}(t/T_s) \quad \underline{Y}_q(t/T_s - 1)]$$

, and the vector b corresponds to:

$$\underline{b} = -2 \cdot \begin{bmatrix} \underline{X}(t/T_s) & \underline{Y}_q(t/T_s - 1) \end{bmatrix}^T \cdot \underline{y}_q(t/T_s)$$

As mentioned above, the feed forward equalizer module 26 and the decision feedback equalizer module 28 are communicatively connected with each other via the processing module 30. In fact, the filter parameter/coefficient of the feed forward equalizer module 26 is set depending on at least one decision feedback equalizer parameter of the decision feedback equalizer module 28.

The respective decision feedback equalizer parameter of the decision feedback equalizer module 28 may be derived from the output signal of the decision feedback equalizer module 28 that has been forwarded to the processing module 30. Alternatively, the processing module 30 gathers the respective filter parameters of the decision feedback equalizer module 28 directly.

Generally, the processing module 30 generates a cost function that is minimized in order to find the respective setting of the feed forward equalizer parameter. The cost function may relate to an error squared between the output signals of the respective equalizer modules 26, 28. Hence, the respective cost function is minimized in order to identify the respective setting for the feed forward equalizer parameter.

The respective cost function to be minimized can be expressed as follows:

$$K = \begin{bmatrix} \underline{X}_{\ddot{a}quFFE}(t/T_s) \cdot \underline{h}_{\ddot{a}quFFE} - \underline{X}(t/T_s) \cdot \underline{h}_{FFE} - \underline{Y}_q(t/T_s - 1) \cdot \underline{h}_{DFE} \end{bmatrix}^T$$
$$\cdot \begin{bmatrix} \underline{X}_{\ddot{a}quFFE}(t/T_s) \cdot \underline{h}_{\ddot{a}quFFE} - \underline{X}(t/T_s) \cdot \underline{h}_{FFE} - \underline{Y}_q(t/T_s - 1) \cdot \underline{h}_{DFE} \end{bmatrix}$$

The impulse response of the equivalent FFE module 26 is expressed by:

$$\underline{h}_{\ddot{a}quiFFE} = \begin{bmatrix} h_0 & h_1 & \cdots & h_{L_{\ddot{a}quFFE}-1} \end{bmatrix}^T$$

The time and value discrete input signal of the equivalent FFE module 26 is expressed by:

$$\underline{X}_{\ddot{a}quFFE}(t/T_s) = \begin{bmatrix} \underline{x}^T(t/T_s + T_{D,\ddot{a}quFFE}/T_s) & \underline{x}^T(t/T_s + T_{D,\ddot{a}quFFE}/T_s - 1) & \cdots & \underline{x}^T(t/T_s + T_{D,\ddot{a}quFFE}/T_s - N + 1) \end{bmatrix}^T$$

The cost function K becomes minimized by

$$\underline{h}_{\ddot{a}quFFE} = -1/2 \cdot \underline{\underline{A}}^{-1} \cdot \underline{b}$$

wherein the matrix A is

$$\underline{\underline{A}} = \underline{X}^T_{\ddot{a}quFFE}(t/T_s) \cdot \underline{X}_{\ddot{a}quFFE}(t/T_s)$$

And wherein the vector b is:

$$\underline{b} = -2 \cdot \underline{X}^T_{\ddot{a}quFFE}(t/T_s) \cdot \begin{bmatrix} \underline{X}(t/T_s) \cdot \underline{h}_{FFE} + \underline{Y}_q(t/T_s - 1) \cdot \underline{h}_{DFE} \end{bmatrix}$$

As shown in Figure 1, the parallel filter structure 20 is implemented on a single chip 32, for instance an application-specific integrated circuit (ASIC).

The chip 32 may have a real time section 34 as well as a non-real time section 36 that are used for different purposes.

The feed forward equalizer module 26 is implemented in the real time section 34, whereas the decision feedback equalizer module 28 is implemented in the non-real time section 36 of the chip 32.

Further, the parallel filter structure 20 comprises at least one (output) interface 38 that is associated with the feed forward equalizer module 26 such that the output signal of the feed forward equalizer module 26 is fed to the interface 38 that may be associated with a trigger module 40.

The trigger module 40 may be part of the parallel filter structure 20 such that the trigger module 40 is also implemented on the chip 32. Alternatively, the trigger module 40 is established as a separately formed module that is provided on a separately formed chip within the oscilloscope 10.

Further, the parallel filter structure 20 may comprise another output interface 42 that is associated with the decision feedback equalizer module 28 such that the output signal of the decision feedback equalizer module 28 is fed to the output interface 42 that is associated with an eye diagram module 44.

The eye diagram module 44 may be implemented on the chip 32 or on a separately formed chip that is connected with the chip 32 on which the parallel filter structure 20 is implemented.

The parallel filter structure 20, particularly the parallel circuit 24, ensures that the output signals of the different equalizer modules 26, 28 are equivalent with each other since the filter parameters of the feed forward equalizer module 26 are set accordingly as described above. The equivalence is ensured by means of minimizing the cost function, namely the error squared between the output signals of the equalizer modules 26, 28.

Accordingly, both equalizer modules 26, 28 have the same transfer function, resulting in similar or rather equivalent equalizing functions.

Therefore, the oscilloscope 10 is enabled to provide a real-time processing wherein the equalization functions have the same characteristics in a triggering path and a displaying path of the oscilloscope 10.

Certain embodiments disclosed herein, particularly the respective module(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

**Claims**

1. A parallel filter structure for processing a signal, wherein the parallel filter structure (20) comprises a signal input (22) configured to receive a time and value discrete input signal, wherein the parallel filter structure (20) comprises a feed forward equalizer module (26) connected with the signal input (22) for receiving the time and value discrete input signal, wherein the parallel filter structure (20) comprises a decision feedback equalizer module (28) connected with the signal input (22) for receiving the time and value discrete input signal, **characterized in that** the feed forward equalizer module (26) and the decision feedback equalizer module (28) together form a parallel circuit (24) such that both equalizer modules (26, 28) process the same time and value discrete input signal in parallel.

2. The parallel filter structure according to claim 1, wherein the feed forward equalizer module (26) and the decision feedback equalizer module (28) are communicatively connected with each other.

3. The parallel filter structure according to claim 1 or 2, wherein at least one feed forward equalizer parameter of the feed forward equalizer module (26) is set depending on at least one decision feedback equalizer parameter of the decision feedback equalizer module (28).

**4.** The parallel filter structure according to any of the preceding claims, wherein the dependency is determined based on a minimum of a cost function, in particular wherein the parallel filter structure (20) comprises a processing module (30) that is configured to minimize the cost function.

**5.** The parallel filter structure according to claim 4, wherein the cost function comprises the error squared between an output signal of the feed forward equalizer module (26) and an output signal of the decision feedback equalizer module (28).

**6.** The parallel filter structure according to any of the preceding claims, wherein the parallel filter structure (20) is implemented on a single chip (32), particularly an application-specific integrated circuit (ASIC).

**7.** The parallel filter structure according to claim 6, wherein the feed forward equalizer module (26) is implemented in a real time section (34) of the chip (32).

**8.** The parallel filter structure according to claim 6 or 7, wherein the decision feedback equalizer module (28) is implemented in a non-real time section (36) of the chip (32).

**9.** The parallel filter structure according to any of the preceding claims, wherein an output signal of the feed forward equalizer module (26) is fed to an interface (38) for a trigger module (40), in particular wherein the parallel filter structure (20) comprises the trigger module (40) that is connected with the feed forward equalizer module (26).

**10.** The parallel filter structure according to any of the preceding claims, wherein an output signal of the decision feedback equalizer module (28) is fed to an interface (42) for an eye diagram module (44), in particular wherein the parallel filter structure (20) comprises the eye diagram module (44) that is connected with the decision feedback equalizer module (28).

**11.** An oscilloscope with the parallel filter structure (20) according to any of the preceding claims.

**12.** The oscilloscope according to claim 11, wherein the oscilloscope (10) comprises a trigger module (40) that is connected with an interface (38) associated with the feed forward equalizer module (26) that is separately formed with respect to the trigger module (40).

**13.** The oscilloscope according to claim 11 or 12, wherein the oscilloscope (10) comprises an eye diagram module (44) that is connected with an interface (42) associated with the decision feedback equalizer module (28) that is separately formed with respect to the eye diagram module (44).

**14.** A method of processing a signal, wherein the method comprises the steps of:

- Receiving a time and value discrete input signal via a signal input (22),
- Filtering the time and value discrete input signal by means of a feed forward equalizer module (26) of a parallel filter structure (20),
- Filtering the time and value discrete input signal by means of a decision feedback equalizer module (28) of the parallel filter structure (20), which together with the feed forward equalizer module (26) forms a parallel circuit (24) of the parallel filter structure (20) such that both equalizer modules (26, 28) process the same time and value discrete input signal in parallel.

**15.** The method according to claim 14, wherein at least one feed forward equalizer parameter of the feed forward equalizer module (26) is set depending on at least one decision feedback equalizer parameter of the decision feedback equalizer module (28), in particular wherein the dependency is determined based on a minimum of a cost function, preferably wherein the cost function comprises the error squared between an output signal of the feed forward equalizer module (26) and an output signal of the decision feedback equalizer module (28).

**Patentansprüche**

**1.** Parallelfilterstruktur zum Verarbeiten eines Signals, wobei die Parallelfilterstruktur (20) einen Signaleingang (22) umfasst, der konfiguriert ist, um ein zeit- und wertdiskretes Eingangssignal zu empfangen, wobei die Parallelfilterstruktur (20) ein Vorwärtsentzerrermodul (26), das mit dem Signaleingang (22) verbunden ist, zum Empfangen des zeit- und wertdiskreten Eingangssignals umfasst, wobei die Parallelfilterstruktur (20) ein Entscheidungsrückkopplungsentzerrermodul (28), das mit dem Signaleingang (22) verbunden ist, zum Empfangen des zeit- und wertdiskreten Eingangssignals umfasst, **dadurch gekennzeichnet, dass** das Vorwärtsentzerrermodul (26) und das Entscheidungsrückkopplungsentzerrermodul (28) zusammen eine Parallelschaltung (24) derart ausbilden, dass beide Entzerrermodule (26, 28) das gleiche zeit- und wertdiskrete Eingangssignal parallel verarbeiten.

2. Parallelfilterstruktur nach Anspruch 1, wobei das Vorwärtsentzerrermodul (26) und das Entscheidungsrückkopplungsentzerrermodul (28) miteinander kommunikativ verbunden sind.

3. Parallelfilterstruktur nach Anspruch 1 oder 2, wobei mindestens ein Vorwärtsentzerrerparameter des Vorwärtsentzerrermoduls (26) abhängig von mindestens einem Entscheidungsrückkopplungsentzerrerparameter des Entscheidungsrückkopplungsentzerrermoduls (28) eingestellt ist.

4. Parallelfilterstruktur nach einem der vorstehenden Ansprüche, wobei die Abhängigkeit basierend auf einem Minimum einer Kostenfunktion bestimmt wird, wobei insbesondere die Parallelfilterstruktur (20) ein Verarbeitungsmodul (30) umfasst, das konfiguriert ist, um die Kostenfunktion zu minimieren.

5. Parallelfilterstruktur nach Anspruch 4, wobei die Kostenfunktion das Fehlerquadrat zwischen einem Ausgangssignal des Vorwärtsentzerrermoduls (26) und einem Ausgangssignal des Entscheidungsrückkopplungsentzerrermoduls (28) umfasst.

6. Parallelfilterstruktur nach einem der vorstehenden Ansprüche, wobei die Parallelfilterstruktur (20) auf einem einzelnen Chip (32), insbesondere einer anwendungsspezifischen integrierten Schaltung (ASIC), implementiert ist.

7. Parallelfilterstruktur nach Anspruch 6, wobei das Vorwärtsentzerrermodul (26) in einem Echtzeitabschnitt (34) des Chips (32) implementiert ist.

8. Parallelfilterstruktur nach Anspruch 6 oder 7, wobei das Entscheidungsrückkopplungsentzerrermodul (28) in einem Nichtechtzeitabschnitt (36) des Chips (32) implementiert ist.

9. Parallelfilterstruktur nach einem der vorstehenden Ansprüche, wobei ein Ausgangssignal des Vorwärtsentzerrermoduls (26) einer Schnittstelle (38) für ein Triggermodul (40) zugeführt wird, wobei insbesondere die Parallelfilterstruktur (20) das Triggermodul (40) umfasst, das mit dem Vorwärtsentzerrermodul (26) verbunden ist.

10. Parallelfilterstruktur nach einem der vorstehenden Ansprüche, wobei ein Ausgangssignal des Entscheidungsrückkopplungsentzerrermoduls (28) einer Schnittstelle (42) für ein Augendiagrammmodul (44) zugeführt wird, wobei insbesondere die Parallelfilterstruktur (20) das Augendiagrammmodul (44) umfasst, das mit dem Entscheidungsrückkopplungsentzerrermodul (28) verbunden ist.

11. Oszilloskop mit der Parallelfilterstruktur (20) nach einem der vorstehenden Ansprüche.

12. Oszilloskop nach Anspruch 11, wobei das Oszilloskop (10) ein Triggermodul (40) umfasst, das mit einer Schnittstelle (38) verbunden ist, die dem Vorwärtsentzerrermodul (26) zugeordnet ist, das in Bezug auf das Triggermodul (40) separat ausgebildet ist.

13. Oszilloskop nach Anspruch 11 oder 12, wobei das Oszilloskop (10) ein Augendiagrammmodul (44) umfasst, das mit einer Schnittstelle (42) verbunden ist, die dem Entscheidungsrückkopplungsentzerrermodul (28) zugeordnet ist, das in Bezug auf das Augendiagrammmodul (44) separat ausgebildet ist.

14. Verfahren zum Verarbeiten eines Signals, wobei das Verfahren die Schritte umfasst:

- Empfangen eines zeit- und wertdiskreten Eingangssignals über einen Signaleingang (22),
- Filtern des zeit- und wertdiskreten Eingangssignals mittels eines Vorwärtsentzerrermoduls (26) einer Parallelfilterstruktur (20),
- Filtern des zeit- und wertdiskreten Eingangssignals mittels eines Entscheidungsrückkopplungsentzerrermoduls (28) der Parallelfilterstruktur (20), das zusammen mit dem Vorwärtsentzerrermodul (26) eine Parallelschaltung (24) der Parallelfilterstruktur (20) derart ausbildet, dass beide Entzerrermodule (26, 28) das gleiche zeit- und wertdiskrete Eingangssignal parallel verarbeiten.

15. Verfahren nach Anspruch 14, wobei mindestens ein Vorwärtsentzerrerparameter des Vorwärtsentzerrermoduls (26) abhängig von mindestens einem Entscheidungsrückkopplungsentzerrerparameter des Entscheidungsrückkopplungsentzerrermoduls (28) eingestellt wird, wobei insbesondere die Abhängigkeit basierend auf einem Minimum einer Kostenfunktion bestimmt wird, wobei vorzugsweise die Kostenfunktion das Fehlerquadrat zwischen einem Ausgangssignal des Vorwärtsentzerrermoduls (26) und einem Ausgangssignal des Entscheidungsrückkopplungsentzerrermoduls (28) umfasst.

**Revendications**

1. Structure de filtre parallèle pour le traitement d'un signal, dans laquelle la structure de filtre parallèle (20) comprend une entrée de signal (22) configurée pour recevoir un signal d'entrée à temps discret et à valeur discrète, dans laquelle la structure de filtre parallèle (20) comprend un module d'égaliseur à action directe (26) connecté à l'entrée de signal (22) pour recevoir le signal d'entrée à temps discret et à valeur discrète, dans laquelle la structure de filtre parallèle (20) comprend un module d'égaliseur à rétroaction de décision (28) connecté à l'entrée de signal (22) pour recevoir le signal d'entrée à temps discret et à valeur discrète, **caractérisée en ce que** le module d'égaliseur à action directe (26) et le module d'égaliseur à rétroaction de décision (28) forment ensemble un circuit parallèle (24) de sorte que les deux modules d'égaliseur (26, 28) traitent en parallèle le même signal d'entrée à temps discret et à valeur discrète.

2. Structure de filtre parallèle selon la revendication 1, dans laquelle le module d'égaliseur à action directe (26) et le module d'égaliseur à rétroaction de décision (28) sont connectés de manière communicative l'un à l'autre.

3. Structure de filtre parallèle selon la revendication 1 ou 2, dans laquelle au moins un paramètre d'égaliseur à action directe du module d'égaliseur à action directe (26) est réglé en fonction d'au moins un paramètre d'égaliseur à rétroaction de décision du module d'égaliseur à rétroaction de décision (28).

4. Structure de filtre parallèle selon l'une quelconque des revendications précédentes, dans laquelle la dépendance est déterminée sur la base d'un minimum d'une fonction de coût, en particulier dans laquelle la structure de filtre parallèle (20) comprend un module de traitement (30) qui est configuré pour minimiser la fonction de coût.

5. Structure de filtre parallèle selon la revendication 4, dans laquelle la fonction de coût comprend l'erreur quadratique entre un signal de sortie du module d'égaliseur à action directe (26) et un signal de sortie du module d'égaliseur à rétroaction de décision (28).

6. Structure de filtre parallèle selon l'une quelconque des revendications précédentes, dans laquelle la structure de filtre parallèle (20) est implémentée sur une seule puce (32), en particulier un circuit intégré spécifique à une application (ASIC).

7. Structure de filtre parallèle selon la revendication 6, dans laquelle le module d'égaliseur à action directe (26) est implémenté dans une section temps réel (34) de la puce (32).

8. Structure de filtre parallèle selon la revendication 6 ou 7, dans laquelle le module d'égaliseur à rétroaction de décision (28) est implémenté dans une section temps non réel (36) de la puce (32).

9. Structure de filtre parallèle selon l'une quelconque des revendications précédentes, dans laquelle un signal de sortie du module d'égaliseur à action directe (26) est envoyé à une interface (38) pour un module de déclenchement (40), en particulier dans laquelle la structure de filtre parallèle (20) comprend le module de déclenchement (40) qui est connecté au module d'égaliseur à action directe (26).

10. Structure de filtre parallèle selon l'une quelconque des revendications précédentes, dans laquelle un signal de sortie du module d'égaliseur à rétroaction de décision (28) est envoyé à une interface (42) pour un module de diagramme de l'oeil (44), en particulier dans laquelle la structure de filtre parallèle (20) comprend le module de diagramme de l'oeil (44) qui est connecté au module d'égaliseur à rétroaction de décision (28).

11. Oscilloscope doté de la structure de filtre parallèle (20) selon l'une quelconque des revendications précédentes.

12. Oscilloscope selon la revendication 11, dans lequel l'oscilloscope (10) comprend un module de déclenchement (40) qui est connecté à une interface (38) associée avec le module d'égaliseur à action directe (26) qui est formé séparément par rapport au module de déclenchement (40).

**13.** Oscilloscope selon la revendication 11 ou 12, dans lequel l'oscilloscope (10) comprend un module de diagramme de l'oeil (44) qui est connecté à une interface (42) associée avec le module d'égaliseur à rétroaction de décision (28) qui est formé séparément par rapport au module de diagramme de l'œil (44).

**14.** Procédé de traitement d'un signal, dans lequel le procédé comprend les étapes consistant à :

- Récevoir un signal d'entrée à temps discret et à valeur discrète par l'intermédiaire d'une entrée de signal (22),
- Filtrer le signal d'entrée à temps discret et à valeur discrète au moyen d'un module d'égaliseur à action directe (26) d'une structure de filtre parallèle (20),
- Filtrer le signal d'entrée à temps discret et à valeur discrète au moyen d'un module d'égaliseur à rétroaction de décision (28) de la structure de filtre parallèle (20), qui, avec le module d'égaliseur à action directe (26), forme un circuit parallèle (24) de la structure de filtre parallèle (20) de sorte que les deux modules d'égaliseur (26, 28) traitent en parallèle le même signal d'entrée à temps discret et à valeur discrète.

**15.** Procédé selon la revendication 14, dans lequel au moins un paramètre d'égaliseur à action directe du module d'égaliseur à action directe (26) est réglé en fonction d'au moins un paramètre d'égaliseur à rétroaction de décision du module d'égaliseur à rétroaction de décision (28), en particulier dans lequel la dépendance est déterminée sur la base d'un minimum d'une fonction de coût, de préférence dans lequel la fonction de coût comprend l'erreur quadratique entre un signal de sortie du module d'égaliseur à action directe (26) et un signal de sortie du module d'égaliseur à rétroaction de décision (28).

**Fig. 1**

Receiving a time and value
discrete input signal

↓

Filtering by a FFE / Filtering by a DFE

**Fig. 2**

Fig. 3

Fig. 4

**EP 4 027 149 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9077574 B1
- US 2016344372 A1
- US 2005220185 A1